(19) Europäisches Patentamt
European Patent Office
Office européen des brevets

(11) **EP 1 977 505 B1**

(12) **EUROPEAN PATENT SPECIFICATION**

(45) Date of publication and mention
of the grant of the patent:
**06.03.2013 Bulletin 2013/10**

(51) Int Cl.:
*H03F 1/34* (2006.01)     *H03F 3/183* (2006.01)
*H03F 3/45* (2006.01)

(21) Application number: **07702887.6**

(22) Date of filing: **19.01.2007**

(86) International application number:
**PCT/EP2007/000456**

(87) International publication number:
**WO 2007/085383 (02.08.2007 Gazette 2007/31)**

(54) **SIGNAL CONDITIONING CIRCUIT**

SIGNALKONDITIONIERUNGSSCHALTUNG

CONDITIONNEUR DE SIGNAL

(84) Designated Contracting States:
**AT BE BG CH CY CZ DE DK EE ES FI FR GB GR HU IE IS IT LI LT LU LV MC NL PL PT RO SE SI SK TR**

(30) Priority: **24.01.2006 IT MI20060113**

(43) Date of publication of application:
**08.10.2008 Bulletin 2008/41**

(73) Proprietor: **Politecnico Di Milano**
**20133 Milano (IT)**

(72) Inventors:
• **ANDREONI, Giuseppe**
**I-20053 Muggio' (IT)**

• **PICCINI, Luca**
**I-20137 Milano (IT)**
• **MAGGI, Luca**
**I-24121 Bergamo (IT)**

(74) Representative: **Ciceri, Fabio et al**
**Perani & Partners**
**Piazza San Babila, 5**
**20122 Milano (IT)**

(56) References cited:
**US-A- 2 033 330**     **US-A- 3 972 002**
**US-A- 4 189 681**     **US-A- 4 257 006**
**US-A- 5 444 418**

**Description**

The present invention relates to a signal conditioning circuit according to the preamble of claim 1.

The term "signal conditioning", as used herein, includes a signal amplification stage and a signal filtering stage.

For the sake of simplicity, reference will be particularly made herein, without limitation, to broadband information signals such as those listed below:

Table 1

| Source | Amplitude | Bandwidth |
|---|---|---|
| ECG (Electrocardiogram) | 0.1 - 5mV | 0.05 - 130Hz |
| EEG (Electroencephalogram) | 10- 100$\mu$V | 0.5 - 70Hz |
| EMG (Electromyogram) | 100$\mu$V- 1mV | 20 - 2000Hz |
| EOG (Electrooculogram) | 0.01 - 0.1mV | dc - 10Hz |

The conditioning circuit of the present invention is particularly suitable for use in amplification and filtering (i.e. conditioning) operations, mainly but without limitation of the band-pass type, on the signals indicated above in Table 1. Concerning the above mentioned signal conditioning circuits, the need is highly felt of providing circuits that can meet the following requirements:

-    low supply voltage;
-    low power consumption;
-    high gain;
-    large dynamic reserve;
-    stability in the proximity of the DC component of the signal;
-    linearity; and
-    simple construction.

In this respect, it will be understood that, in many applications, such as in remote monitoring systems, wearable systems or portable systems in general, the above requirements are only partly met, as they are in conflict with the inherent technological restrictions of the devices that are used in the circuits.

Further limitations of traditional topologies are:

-    a small dynamic reserve;
-    a large size, and hence higher production costs and lower usability. Furthermore, acquisition conditions entail limitations such as:
-    input signal offset;
-    out of band noise;
-    low-frequency artifacts or drifts in the input signal.

In an attempt to obviate the above problems, a signal conditioning circuit has first been conceived which could provide a high gain. This requirement was met by providing an amplification circuit (or chain) composed of several amplifier elements in series. An example can be found in patent document US 4,257,006.

While this solution proves to be satisfactory, it still has a number of drawbacks associated to the offsets introduced by the amplifier elements and to low-frequency drifts in signals. Such drifts may particularly cause saturation of the amplifier element acting as the output stage or of an intermediate element of the chain.

A possible alternative solution has been to cascade high-pass filter elements between each pair of amplifier elements of the chain.

While this circuit solution has the important advantage that the overall amplification chain offset is only given by the last amplification stage, it still proves to be unsatisfactory for the following reasons:

-    the need to use a large number of components to implement the circuit solution; and
-    should an abrupt input signal variation occur at the input of the amplifier chain, for instance during circuit warm-up time, this would trigger a slow recovery, during which the information content of the signal would be lost.

In an attempt to obviate the latter drawback, a circuit was introduced that could both detect saturation of the output stage (or an intermediate stage) and dynamically change circuit parameters for prompt recovery of linear operation.

Nevertheless this solution still has certain drawbacks. Namely, the implementation of this circuit solution involves a dramatically increased circuit complexity, and an associated cost increase.

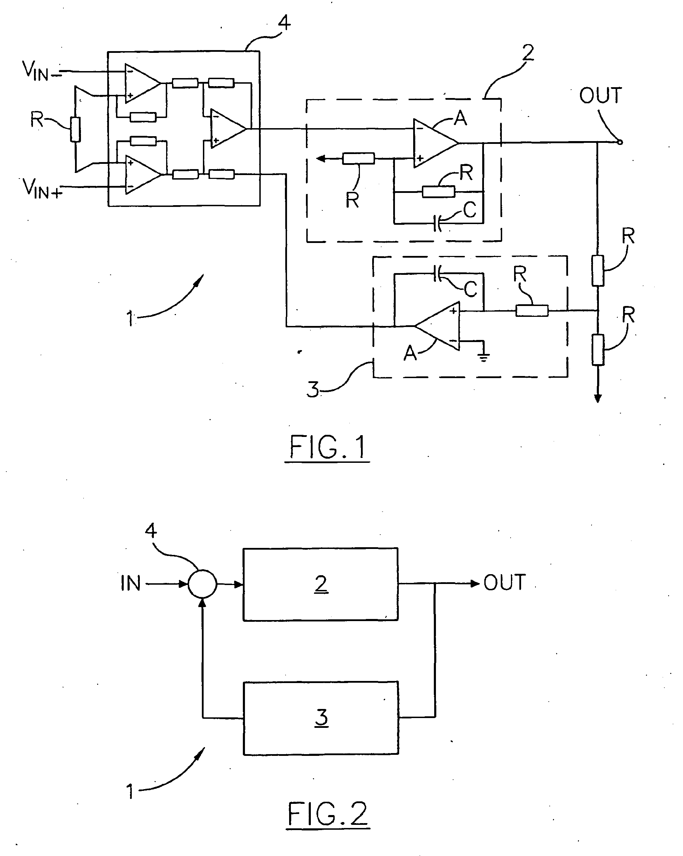

A further prior art arrangement is shown in Figures 1 and 2.

These figures are schematic views of a circuit solution (Figure 1) and a corresponding block model (Figure 2) of a circuit 1 that can provide systemic compensation of signals like those mentioned above, at the input terminal IN.

The circuit 1 comprises a conditioning stage 2, which acts as a band-pass amplifier (Filtered Amplifier), and receives feedback by another stage 3. The latter acts as an Integration to provide compensation of the signal at the input terminal IN.

The circuit 1 further comprises an input stage 4 having inputs $V_{IN}^+$ and $V_{IN}^-$, which acts as a preamplifier (Instrumentation Amplifier). Such input stage 4 is connected with the stage 2 (Filtered Amplifier) and the stage 3 (Integration).

In the circuit diagram of Figure 1, further passive and/or active devices are shown, such as resistors R, capacitors C and operational amplifiers A, whose sizes and operations are well known to those of ordinary skill in the art and will not be described in detail herein.

Particularly, the circuit 1 provides compensation of the signal at the input terminal IN by using the Integration 2, which operates directly on the whole amplification chain.

The circuit configuration of Figure 1 has been found to be able to restore the input signal baseline when the output OUT of the stage 2 is in an offset condition.

However, should the output OUT of the stage 2 be in a saturated state, the recovery transient would be composed of a part in which the circuit configuration 1 has a nonlinear operation and a part in which it has a linear operation.

It was found that the time required for complete restoration of linear operation in the circuit configuration 1 is often a few orders of magnitude longer than the period corresponding to the minimum frequency of the input signal passband.

During the time the circuit configuration 1 has a nonlinear operation, the information content of the signal is obviously lost, thereby causing easily imaginable drawbacks.

In view of the above prior art, the object of the present invention is to provide a circuit having:

- lower supply voltage;
- lower power consumption;
- reduced circuit complexity;
- a maximized dynamic reserve for the relevant bandwidth; and
- an amplification chain that is non susceptible to low frequency artifacts and/or signal drifts.

According to the present invention, this object is fulfilled by a signal conditioning circuit as defined in the independent claim 1.

The present invention provides a circuit ensuring feedback loop stability regardless of the gain and dynamics of the individual blocks.

Furthermore, the inventive circuit, affords freedom in nonlinear feedback management, for prompt offset compensation.

Yet, the inventive circuit exhibits high tolerance to input signal offset, high filtering and amplification accuracy, large dynamic reserve and low harmonic distortion.

Also, thanks to the present invention, under equal dynamic reserve conditions, the circuit allows to operate at lower supply voltages, thereby reducing power consumption.

Finally, the inventive circuit has a very simple circuit construction as compared with prior art circuits.

The features and advantages of the invention will appear from the following detailed description of one practical embodiment, which is illustrated without limitation in the annexed drawings, in which:

- Figure 1 is a circuit diagram according to the prior art;
- Figure 2 is a block diagram of the circuit of Figure 1;
- Figure 3 is a block diagram of the feed-back circuit according to the present invention;
- Figure 4 is a possible circuit implementation of the block diagram of Figure 3;
- Figure 5 is a root locus plot for the circuit of Figure 3.

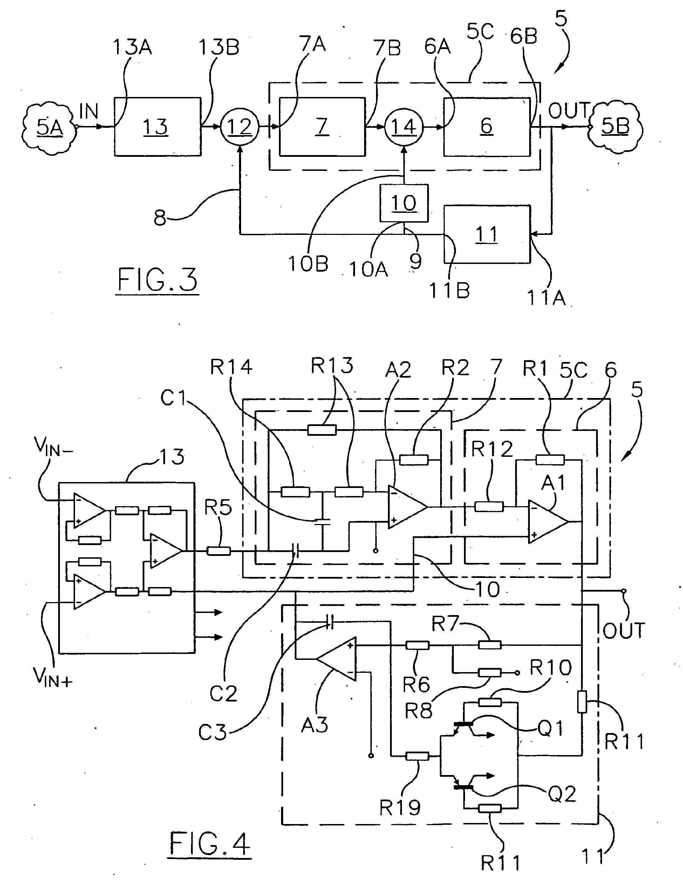

Figures 3 to 5 show a block diagram of a circuit for conditioning signals of the type indicated in Table 1 hereinbefore.

Further types of signals that can be conditioned by the inventive circuit as described below are, for instance, temperature and/or humidity signals, ventilation and/or illumination signals, vibration and/or micromotion and/or acceleration signals, radio-frequency and telecommunication signals in general.

The circuit 5 has an input terminal IN and an output terminal OUT for connecting a signal source 5A to a utilization device 5B.

The conditioning circuit 5 comprises:

- an amplification and filtering chain 5C;
- said amplification and filtering chain 5C comprising amplifier means 6 and filter means 7, each having an input connection 6A and 7B and an output connection 6B and 7B;
- a first feedback path 8 for providing feedback to said amplification and filtering network 5C.

The first feedback path 8 includes a first phase-shifting network 11, the latter having an input connection 11A and an output connection 11B.

Advantageously, the inventive circuit 5 has a second feedback path 9 for providing feedback to the amplifier means 6.

Particularly, the second feedback path 9 includes a second phase-shifting network 10, the latter having, an input connection 10A and an output connection 10B.

It shall be noted that the conditioning circuit 5 further comprises:

- pre-amplifier means 13 connected with said filter means 7; and
- a first summation node 12.

In accordance with the embodiment as shown in Figure 3, the preamplifier means 13 are connected with the filter means 7 through the first summation node 12.

Particularly, the first summation node 12 can receive, at its input, the output connection 13B of the preamplifier means 13 and the output connection 11B of the first phase-shifting network 11.

The first summation node 12 can connect its output with the input connection 7A of the filter means 7.

Advantageously, the input connection 11A of the first phase-shifting network 11 is connected with the output connection 6B of the amplifier means 6 and the output connection 11B of the first phase-shifting network 11 is connected with the input connection 10A of the second phase-shifting network 10 and with the input connection 7A of the filter means 7.

It shall be noted that, in the embodiment as shown in Figure 4, the first summation node 12 may be integrated in the preamplifier means 13.

It shall be noted that the circuit 5 has a second summation node 14 which is interposed between the filter means 7 and the amplifier means 6.

Particularly, this second summation node 14 can receive at its input the output connections 7B and 10B of the filter means 7 and the second phase-shifting network 10 respectively, and can connect its output with the input connection 6A of the amplifier means 6.

In the preferred embodiment of the present invention, as shown in Figure 3, the filter means 7 are placed before the amplifier means 6, which means that the signal generated by the signal source 5A at the input terminal IN is first subjected to filtering and then to amplification.

Advantageously, such arrangement of the filter means 7 and the amplifier means 6 allows to suppress the noise outside the band of interest immediately after the preamplifier block.

This ensures attenuation of the noise outside the band of interest (Table 1) before the amplifier block 6, thereby allowing all filter means 7 to have a small signal operation and reducing all non ideality problems of the filter.

A further advantage provided by this arrangement consists in that the amplifier block 6 can directly exert its function on the signal to be amplified, as the signal portion outside the band of interest has already be suppressed by the filter means 7.

Thus, the output dynamics of the amplifier means 6 may be fully exploited.

Alternatively, the inventive circuit 5 may be implemented by providing the series of amplifier means 6 followed by the filter means 7.

It shall be noted that the first and second feedback paths 8 and 9 are provided as a negative feedback path.

Therefore, the block diagram of the conditioning circuit 5 shows two feedback paths 8 and 9 which, as described in more detail below, provide compensation for any problem affecting low frequency signals at the input connection IN.

It shall be particularly noted that, if B(s) designates the transfer function of the filter means 7, C(s) designates the transfer function of the amplifier means 6, D(s) designates the transfer function of the first phase-shifting network 11 and E(s) designates the transfer function of the second phase-shifting network 10, then the loop gain $G_{loop}$ of the circuit 5 may be expressed by the following formula:

$$G_{loop} = \left[ B(s) + E(s) \right] * C(s) * D(s) \quad (1)$$

Advantageously, by imposing the following relation between the function of the second phase-shifting network 10 and the transfer function of the filtering network 7:

$$B(s) = -E(s) \qquad (2)$$

and particularly by providing that such relation (2) exist for $\omega=0$, stability of the loop gain $G_{loop}$ of the circuit 5 may be achieved regardless of the gain G of the loop formed by the amplifier means 6 and the first phase-shifting network 11.

In other words, the DC gain of the transfer function E(s) of the second phase-shifting network 10 is substantially equal to the opposite of the DC gain of the transfer function B(s) of the filtering chain 7.

Therefore, advantageously, the behavior of the first phase-shifting network 11, i.e. its transfer function, may be changed as desired, while preserving the stability of the circuit 5.

In a preferred embodiment of the present invention, the first phase-shifting network 11 is a compensation network that can be implemented using a low-pass filter.

For instance, a possible implementation of the low-pass filter is an integration stage.

In a preferred embodiment of the present invention, the filter means 7 may be low-pass or band-pass filter means or a notch filter.

These filter means 7 may be further implemented by a combination of one or more of the above filter types.

In a preferred embodiment of the present invention, the preamplifier means 13 may be implemented by an instrumentation amplifier.

Concerning operation of the circuit 5, in the inventive circuit 5 the signal at the output connection 6B of the amplifier means 6, i.e. the signal at the output OUT is picked up and fed back, along the two feedback paths 8 and 9, to two distinct points of the circuit 5, such as the first 12 and the second 14 summation nodes.

Particularly, when the output connection 6B of the amplifier means 6 is in a saturated condition, the first phase-shifting network 11 may promptly compensate the offset of the signal generated by the source signal 5A, found at the input terminal IN, to restore the output connection 6B of the amplifier means 6 to the linear condition in as short a time as possible.

The same operation is obtained when the offset is introduced by any block of the inventive circuits 5. In other words, following detection of a saturated condition at the output connection 6B of the amplifier means 6, the loop gain $G_{loop}$ of the circuit 5 may be increased by many dB, to achieve a quasi immediate recovery of signal variations at the input of the chain.

Particularly, this result may be achieved thanks to the fact that the DC gain of the transfer function of the second phase-shifting network 10 is substantially equal to the opposite of the DC gain of the transfer function of the filtering chain 7.

Indeed, if the DC gain of the transfer function of the second phase-shifting network 10 is set to 1, i.e. $E(\omega=0)$ = 1 - although values of 0.8 to 1.2 are also acceptable - then the DC gain of the transfer function of the filtering network 7, i.e. $B(\omega=0) = -1$, is equal to -1, i.e. the opposite value.

The $G_{loop}$ value of the circuit 5, as expressed by the relation (1) is apparently equal to zero.

This involves stability of the circuit 5, regardless of the type of transfer function of the filter means 7 and the gain of the first phase-shifting network 11 and regardless of the amplifier means 6.

For example, in the case of a signal having a bandwidth of 0.01 Hz to 40 Hz, such as an EEG signal (Table 1), the time needed to restore the linear condition has been found to be about 10 msec, whereas in prior art circuits as shown in Figure 1, even 50 sec. would be needed therefor.

Referring now to Figure 4, a possible circuit embodiment is shown which corresponds to the block diagram described above with reference to Figure 3.

Particularly, this figure shows the circuit implementations of the amplifier means 6, the filter means 7, the preamplifier means 13, the first phase-shifting network 11 and the second phase-shifting network 10.

Circuit implementation of each of these means involves the use of one or more resistors R1 - R13, one or more capacitors C1 - C3 and one or more operational amplifiers A1 - A3.

For example, the amplifier means 6 include an inverting amplifier, which is composed of an operational amplifier A1 which is negatively fed-back by the resistors R1 and R12.

The same considerations can be made concerning the above mentioned means as shown in Figure 4.

Apparently, each of such passive and/or active elements R1 - R13, C1 - C3 and A1 - A3 is sized as a function of the specific signal at the input terminals $V_{IN}^{+}$ and $V_{IN}^{-}$.

The operation of amplifier 6, filter 7 and preamplifier 13 blocks may be easily understood and will not be described in detail herein.

However, the operation of the second phase-shifting network 11 will be described below.

It shall be first noted that the second phase-shifting network 10 in the second feedback path 9 is a simple connection line.

This means that the DC gain of the transfer function of the second phase-shifting network 10 is equal to 1, therefore the DC gain of the transfer function of the filtering network 7 is equal to -1.

Concerning the operation of the second phase-shifting network 11, as long as the output connection 6B has a linear operation, the transistors Q1 and Q1 are off, and the forward line of the circuit 5 is only fed-back by the first phase-shifting network 11.

The potential divider, composed of the resistors R8 and R7, allows to adjust the position of the high-pass pole introduced by the first phase-shifting network 11 as desired.

If the output connection 6B saturates, i.e. the output connection OUT of the circuit 5 saturates, in this example the transistors Q1 and Q2 are switched on and considerably increase the gain of the second phase-shifting network 11.

This provides immediate compensation, and restores the output connection OUT of the circuit 5 to linear operation.

It shall be noted that, the embodiment as shown in Figure 4 comprises a smaller number of components than prior art circuits, wherefore static power consumption is reduced.

It will further be appreciated that dynamic power consumption of the circuit 5 is also greatly reduced.

Power consumption is related to the amplitude of the input signal, but thanks to the inventive circuit, dynamic power consumption is limited to the information part of the input signal and does not include noise.

This may be achieved thanks to the following:

- accurate filtering by the filter means 7, which are implemented in this specific embodiment by means of the low-pass filter;
- suppression of the out-of-band noise from the input signal, before amplification thereof by the amplification stage 6.

It will be further appreciated that increased dynamic reserve and tolerance to input signal offset in the circuit 5 allow operation at lower voltages, under equal input signal conditions.

Alternatively, the compensation network may be based on either analog techniques, using passive or active components, or a mixed analog/digital technique, e.g. using a microcontroller or a DAC.

It will be appreciated that the inherent stability of this configuration allows to use very fast and simple compensation modes, such as threshold compensation.

This affords reduced circuit complexity, in case of analog implementation, and reduced algorithmic complexity, in case of digital implementation.

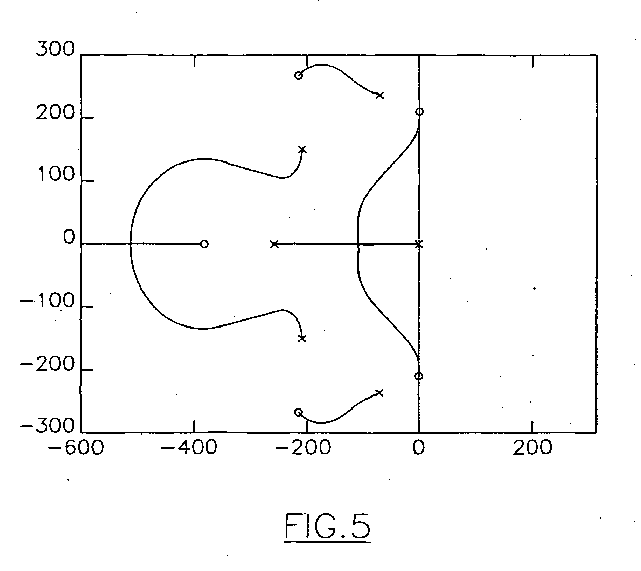

Referring now to Figure 5, the latter shows the root locus plot obtained from the block diagram of Figure 3.

Particularly, Figure 5 shows the root locus of the circuit 5 when the transfer function of the filter means 7 is characterized by five poles.

The circuit 5 was found to be stable in any configuration in which the DC gain of the second phase-shifting network 10 is the opposite of the DC gain of the amplification and filtering block, regardless of the number of poles of the transfer function of the filtering block 7.

Those skilled in the art will obviously appreciate that a number of changes and variants may be made to the configuration as described hereinbefore to meet specific needs, without departure from the scope of the invention, as defined in the following claims.

## Claims

1. A signal conditioning circuit, comprising:

- an amplification and filtering chain (5C) comprising amplifier means (6) and filter means (7), each having an input connection (6A, 7A) and an output connection (6B, 7B);
- a first feedback path (8) for providing feedback to said amplification and filtering network (6, 7);
- said first feedback path (8) including a first phase-shifting network (11) which has an input connection (11A) and an output connection (11B);

**characterized in that** it comprises:

- a second feedback path (9) for providing feedback to said amplifier means (6);
- said second feedback path (9) including a second phase-shifting network (10) which has an input connection (10A) and an output connection (10B);
- said input connection (11A) of said first phase-shifting network (11) being connected with said output connection (6B) of said amplifier means (6);
- said output connection (11B) of said first phase-shifting network (11) being connected with the input connection (10A) of said second phase-shifting network (10) and with said input connection (7A) of said filter means (7);
- said first phase-shifting network (11) being designed to compensate for errors in the output connection (6B) of said amplifier means (6) or to operate when said output connection (6B) of said amplifier means (6) is in a saturated condition.

2. A signal conditioning circuit as claimed in claim 1, **characterized in that** the DC gain value of the transfer function of said second phase-shifting network (10) is substantially equal to the opposite of the DC gain value of the transfer function of said filtering and amplification chain (6, 7).

3. A signal conditioning circuit as claimed in claims 1 to 2, **characterized in that** it further comprises preamplifier means (13), having an input connection (13A) and an output connection (13B), said preamplifier means (13) being connected with said filter means (7) and being adapted to receive said signal to be conditioned at its input.

4. A signal conditioning circuit as claimed in claim 3, **characterized in that** the preamplifier means comprise a first summation node (12) receiving, at its input, the output connection (11B) of said first phase-shifting network (11) and the output connection (13B) of the preamplifier means (13) and the input connection (10A) of said first phase-shifting network (10), said first summation node (12) being adapted to connect its output with the input connection (7A) of said filter means (7).

5. A signal conditioning means as claimed in claims 1 to 4, **characterized in that** it further comprises a second summation node (14) adapted to receive at its input the output connections (7B, 10B) of said filter means (7) and said first phase-shifting network (10) respectively, said second summation node (14) being adapted to connect its output with the input connection (6A) of said amplifier means (6).

6. A signal conditioning circuit as claimed in any one of the preceding claims, **characterized in that** said first phase-shifting network (11) is a low-pass compensation network.

7. A signal conditioning circuit as claimed in claim 6, **characterized in that** said first low-pass compensation network (11) is constructed using passive and/or active components.

8. A signal conditioning circuit as claimed in claim 6, **characterized in that** said first low-pass compensation network (11) is based on an analog-to-digital technique, using a microcontroller or a DAC.

9. A signal conditioning circuit as claimed in claims 1 to 8, **characterized in that** said second phase-shifting network (10) is a high-pass compensation network.

10. A signal conditioning circuit as claimed in claims 1 to 9, **characterized in that** said filter means (7) are low-pass, band-pass or notch filter means.

11. A signal conditioning circuit as claimed in claims 1 to 10, **characterized in that** said first (8) and second (9) feedback paths are a negative feedback path.

**Patentansprüche**

1. Signalkonditionierungsschaltung, umfassend:

- eine Verstärkungs- und Filterkette (5C), die Verstärkermittel (6) und Filtermittel (7) umfasst, die jeweils eine Eingangsverbindung (6A, 7A) und eine Ausgangsverbindung (6B, 7B) aufweisen;
- einen ersten Rückkopplungszweig (8) zum Bereitstellen einer Rückkopplung an das Verstärkungs- und Filternetzwerk (6, 7);
- wobei dieser erste Rückkopplungszweig (8) ein erstes Phasenschiebernetzwerk (11) umfasst, das eine Eingangsverbindung (11 A) und eine Ausgangsverbindung (11 B) aufweist;

**dadurch gekennzeichnet, dass** sie Folgendes umfasst:

- einen zweiten Rückkopplungszweig (9) zum Bereitstellen einer Rückkopplung an die Verstärkermittel (6);
- wobei dieser zweite Rückkopplungszweig (9) ein zweites Phasenschiebernetzwerk (10) umfasst, das eine Eingangsverbindung (10A) und eine Ausgangsverbindung (10B) aufweist;
- wobei diese Eingangsverbindung (11A) des ersten Phasenschiebernetzwerks (11) mit dieser Ausgangsverbindung (6B) der Verstärkermittel (6) verbunden ist;
- wobei diese Ausgangsverbindung (11 B) des ersten Phasenschiebernetzwerks (11) mit der Eingangsverbindung (10A) des zweiten Phasenschiebernetzwerks (10) und mit der Eingangsverbindung (7A) der Filtermittel (7) verbunden ist;
- wobei das erste Phasenschiebernetzwerk (11) dazu gestaltet ist, Fehler in der Ausgangsverbindung (6B) der Verstärkermittel (6) zu kompensieren oder tätig zu werden, wenn sich die Ausgangsverbindung (6B) der Verstärkermittel (6) in einem gesättigten Zustand befindet.

2.  Signalkonditionierungsschaltung nach Anspruch 1, **dadurch gekennzeichnet, dass** der Gleichstromverstärkungswert der Übertragungsfunktion des zweiten Phasenschiebernetzwerks (10) im Wesentlichen gleich dem Gegenwert der Gleichstromverstärkung der Übertragungsfunktion der Filter- und Verstärkungskette (6, 7) ist.

3.  Signalkonditionierungsschaltung nach den Ansprüchen 1 bis 2, **dadurch gekennzeichnet, dass** sie ferner Vorverstärkermittel (13) umfasst, die eine Eingangsverbindung (13A) und eine Ausgangsverbindung (13B) aufweisen, wobei diese Vorverstärkermittel (13) mit den Filtermitteln (7) verbunden und geeignet sind, das zu konditionierende Signal an ihrem Eingang zu empfangen.

4.  Signalkonditionierungsschaltung nach Anspruch 3, **dadurch gekennzeichnet, dass** die Vorverstärkermittel einen ersten Summationsknoten (12) umfassen, der an seinem Eingang die Ausgangsverbindung (11 B) des ersten Phasenschiebernetzwerks (11) und die Ausgangsverbindung (13B) der Vorverstärkermittel (13) und die Eingangsverbindung (10A) des ersten Phasenschiebernetzwerks (10) entgegennimmt, wobei dieser erste Summationsknoten (12) geeignet ist, seinen Ausgang mit der Eingangsverbindung (7A) der Filtermittel (7) zu verbinden.

5.  Signalkonditionierungsmittel nach den Ansprüchen 1 bis 4, **dadurch gekennzeichnet, dass** sie ferner einen zweiten Summationsknoten (14) umfassen, der geeignet ist, an seinem Eingang die Ausgangsverbindungen (7B, 10B) der Filtermittel (7) beziehungsweise des ersten Phasenschiebernetzwerks (10) entgegenzunehmen, wobei dieser zweite Summationsknoten (14) geeignet ist, seinen Ausgang mit der Eingangsverbindung (6A) der Verstärkermittel (6) zu verbinden.

6.  Signalkonditionierungsschaltung nach einem der vorhergehenden Ansprüche, **dadurch gekennzeichnet, dass** das erste Phasenschiebernetzwerk (11) ein Tiefpass-Kompensationsnetzwerk ist.

7.  Signalkonditionierungsschaltung nach Anspruch 6, **dadurch gekennzeichnet, dass** das erste Tiefpass-Kompensationsnetzwerk (11) mit passiven und/oder aktiven Komponenten aufgebaut ist.

8.  Signalkonditionierungsschaltung nach Anspruch 6, **dadurch gekennzeichnet, dass** das erste Tiefpass-Kompensationsnetzwerk (11) unter Verwendung eines Mikrocontrollers oder eines DAU auf Analog-zu-Digital-Technik basiert ist.

9.  Signalkonditionierungsschaltung nach den Ansprüchen 1 bis 8, **dadurch gekennzeichnet, dass** das zweite Phasenschiebernetzwerk (10) ein Hochpass-Kompensationsnetzwerk ist.

10. Signalkonditionierungsschaltung nach den Ansprüchen 1 bis 9, **dadurch gekennzeichnet, dass** die Filtermittel (7) Tiefpass-, Bandpass- oder Notch-Filtermittel sind.

11. Signalkonditionierungsschaltung nach den Ansprüchen 1 bis 10, **dadurch gekennzeichnet, dass** der erste (8) und der zweite (9) Rückkopplungszweig negative Rückkopplungszweige sind.

**Revendications**

1. Circuit de conditionnement de signaux comprenant:

   - une chaîne d'amplification et de filtrage (5C) comprenant des moyens d'amplificateur (6) et des moyens de filtre (7), chacun ayant une connexion d'entrée (6A, 7A) et une connexion de sortie (6B, 7B);
   - une première chaîne de réaction (8) pour fournir une rétroaction audit réseau d'amplification et de filtrage (6, 7);
   - ladite première chaîne de réaction (8) comprenant un premier réseau de déphasage (11) qui a une connexion d'entrée (11A) et une connexion de sortie (11B);

   **caractérisé en ce qu'**il comprend:

   - une deuxième chaîne de réaction (9) pour fournir une rétroaction auxdits moyens d'amplificateur (6);
   - ladite deuxième chaîne de réaction (9) comprenant un deuxième réseau de déphasage (10) qui a une connexion d'entrée (10A) et une connexion de sortie (10B);
   - ladite connexion d'entrée (11A) dudit premier réseau de déphasage (11) étant connectée à ladite connexion de sortie (6B) desdits moyens d'amplificateur (6);
   - ladite connexion de sortie (11B) dudit premier réseau de déphasage (11) étant connectée à la connexion d'entrée (10A) dudit deuxième réseau de déphasage (10) et à ladite connexion d'entrée (7A) desdits moyens de filtre (7);
   - ledit premier réseau de déphasage (11) étant conçu pour compenser des erreurs dans la connexion de sortie (6B) desdits moyens d'amplificateur (6) ou pour fonctionner quand ladite connexion de sortie (6B) desdits moyens d'amplificateur (6) est dans une condition saturée.

2. Circuit de conditionnement de signaux selon la revendication 1, **caractérisé en ce que** la valeur de gain en courant continu de la fonction de transfert dudit deuxième réseau de déphasage (10) est sensiblement égale à l'opposé de la valeur de gain en courant continu de la fonction de transfert de ladite chaîne de filtrage et d'amplification (6, 7).

3. Circuit de conditionnement de signaux selon les revendications 1 à 2, **caractérisé en ce qu'**il comprend en outre des moyens de préamplificateur (13), ayant une connexion d'entrée (13A) et une connexion de sortie (13B), lesdits moyens de préamplificateur (13) étant connectés auxdits moyens de filtre (7) et étant adaptés pour recevoir sur son entrée ledit signal à conditionner.

4. Circuit de conditionnement de signaux selon la revendication 3, **caractérisé en ce que** les moyens de préamplificateur comprennent un premier noeud de sommation (12) recevant, sur son entrée, la connexion de sortie (11B) dudit premier réseau de déphasage (11) et la connexion de sortie (13B) des moyens de préamplificateur (13) et la connexion d'entrée (10A) dudit premier réseau de déphasage (10), ledit premier noeud de sommation (12) étant adapté pour connecter sa sortie à la connexion d'entrée (7A) desdits moyens de filtre (7).

5. Moyens de conditionnement de signaux selon les revendications 1 à 4, **caractérisé en ce qu'**il comprend en outre un deuxième noeud de sommation (14) adapté pour recevoir sur son entrée les connexions de sortie (7B, 10B) desdits moyens de filtre (7) et dudit premier réseau de déphasage (10) respectivement, ledit deuxième noeud de sommation (14) étant adapté pour connecter sa sortie à la connexion d'entrée (6A) desdits moyens d'amplificateur (6).

6. Circuit de conditionnement de signaux selon l'une quelconque des revendications précédentes, **caractérisé en ce que** ledit premier réseau de déphasage (11) est un réseau de compensation passe-bas.

7. Circuit de conditionnement de signaux selon la revendication 6, **caractérisé en ce que** ledit premier réseau de compensation passe-bas (11) est réalisé en utilisant des composants passifs et/ou actifs.

8. Circuit de conditionnement de signaux selon la revendication 6, **caractérisé en ce que** ledit premier réseau de compensation passe-bas (11) est basé sur une technique analogique-numérique, utilisant un microcontrôleur ou un convertisseur numérique-analogique.

9. Circuit de conditionnement de signaux selon les revendications 1 à 8, **caractérisé en ce que** ledit deuxième réseau de déphasage (10) est un réseau de compensation passe-haut.

10. Circuit de conditionnement de signaux selon les revendications 1 à 9, **caractérisé en ce que** lesdits moyens de filtre (7) sont des moyens de filtre passe-bas, passe-bande ou coupe-bande.

11. Circuit de conditionnement de signaux selon les revendications 1 à 10, **caractérisé en ce que** lesdites première (8) et deuxième (9) chaîne de réaction sont une chaîne de réaction négative.

EP 1 977 505 B1

FIG.1

FIG.2

11

FIG.3

FIG.4

FIG.5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4257006 A